Europäisches Patentamt

European Patent Office

Office européen des brevets

Veröffentlichungsnummer: **0 286 018**
**A2**

# EUROPÄISCHE PATENTANMELDUNG

Anmeldenummer: 88105250.0

Anmeldetag: 31.03.88

Int. Cl.4: **G03F 1/00**

Priorität: 09.04.87 DE 3712071

Veröffentlichungstag der Anmeldung:
**12.10.88 Patentblatt 88/41**

Benannte Vertragsstaaten:
**AT BE CH DE ES FR GB IT LI NL**

Anmelder: **BASF Aktiengesellschaft
Carl-Bosch-Strasse 38
D-6700 Ludwigshafen(DE)**

Erfinder: **Eckle, George Albrecht
Richard-Wagner-Strasse 42
D-6711 Beindersheim(DE)**
Erfinder: **Klinsmann, Uwe, Dr.
Mollstrasse 39
D-6800 Mannheim 1(DE)**

Vorlagenmaterial für die Belichtung von lichtempfindlich beschichteten Materialien.

Oberes und unteres Vorlagenmaterial für beidseitig gleichzeitige und paßgenaue Belichtung von lichtempfindlich beschichteten Materialien, beispielsweise Leiterrohplatten, jeweils bestehend aus Trägermaterial mit photographischen Emulsionen, wie Silberhalogenid/Gelatine oder Diazoschichten, wobei das Trägermaterial aus chemisch gehärtetem Glas besteht.

EP 0 286 018 A2

## Vorlagenmaterial für die Belichtung von lichtempfindlich beschichteten Materialien

Die Erfindung betrifft oberes und unteres Vorlagenmaterial für beidseitig gleichzeitige und paßgenaue Belichtung von lichtempfindlich beschichteten Materialien, beispielsweise Leiterrohplatten, jeweils bestehend aus Trägermaterial mit photographischer Emulsion, wie Silberhalogenid/Gelatine oder Diazoschichten.

Es ist bekannt, daß lichtempfindlich beschichtete Materialien, wie beispielsweise Leiterrohplatten, im Kontaktkopierverfahren mittels entsprechender Film-oder Glasvorlagen belichtet werden. Es ist weiterhin bekannt, daß zur Erreichung des notwendigen Kontaktes zwischen den Film-oder Glasvorlagen und den Scheiben des Belichtungsgerätes, der für eine exakte Bildübertragung von den Film-oder Glasvorlagen auf das zu belichtende Material notwendig ist, zwischen den Scheiben des Belichtungsgerätes ein Vakuum von ≤ 0,2 bar angelegt wird. Ferner ist bekannt, beim Belichten von Leiterrohplatten die notwendige Belichtung beider Seiten aus Gründen der Produktivität gleichzeitig durchzuführen.

Durch die Fortschreitung der Miniaturisierung in der Elektronikfertigung sind der präzisen Kontaktbelichtung von Leiterrohplatten mit photographischem Filmmaterial mit Polyesterfolie als Trägermaterial zunehmend Grenzen gesetzt, da dieses Filmmaterial durch Temperatureinflüsse und Luftfeuchtigkeit keine ausreichende Dimensionsstabilität besitzt. Deshalb wurden inzwischen vermehrt sogenannte Glasmaster - mit photographischer Emulsion beschichtete 5 mm starke Glasplatten -eingesetzt. Die außerordentlich hohe Dimensionsstabilität des Glases erlaubt präzise Belichtung auch bei großen Formaten der Leiterrohplatten.

Nachteilig ist jedoch, daß das für die Glasmaster bisher verwendete Floatglas nur bedingt bruchfest ist, so daß mit dieser Art Glasmaster eine beidseitig gleichzeitige Belichtung unter Vakuum nicht möglich ist. Vielmehr werden herkömmliche Glasmaster ausschließlich für einseitige Belichtungen verwendet, wobei das Paket Glasmaster/Leiterrohplatte auf der nicht zu belichtenden Seite mit einer weichen Gummimatte abgedeckt ist, die gleichzeitig als Dichtmaterial für das Anlegen des Vakuums dient. Diese Anordnung erlaubt eine Kontaktbelichtung mit ausreichender Bruchsicherheit des Glasmasters, allerdings mit dem Nachteil, daß nur einseitig belichtet werden kann.

Der Erfindung lag daher die Aufgabe zugrunde, ein geeignetes Trägermaterial für photographische Schichten, wie Silberhalogenid/Gelatine oder Diazoschichten, zu ermitteln, das dimensionsstabil gegen Änderungen der Luftfeuchtigkeit und der Temperatur ist und das gleichzeitig eine Flexibilität aufweist, die einen Einsatz zum Kontaktkopieren unter Vakuum von ≤ 0,2 bar erlaubt.

Diese Aufgabe wird erfindungsgemäß dadurch gelöst, daß das Trägermaterial aus chemisch gehärtetem Glas besteht.

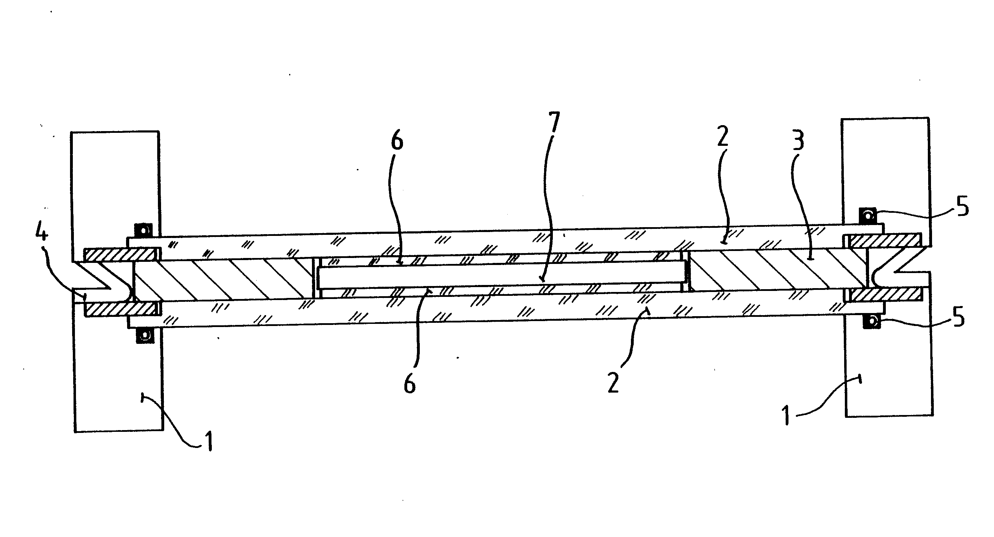

Ein Ausführungsbeispiel ist in der Zeichnung dargestellt und wird nachstehend im Detail beschrieben:

Die Zeichnung zeigt einen Querschnitt durch eine Belichtungseinheit eines Belichtungsgerätes, bestehend aus Metallrahmen 1, zwei Glasplatten 2 ≙ Vakuumscheiben, die in dem Metallrahmen gelagert sind und einem Distanzrahmen 3, durch den die Glasplatten auf einem vorgegebenen Abstand zueinander gehalten werden. Der Raum zwischen den Glasplatten und dem Distanzrahmen -wird bei Vakuum in diesem Raum - mittels einer umlaufenden V-Dichtung 4 und zwei umlaufenden, aufblasbaren Schlauchdichtungen 5 gegen die Atmosphäre abgedichtet.

Das erfindungsgemäße obere und untere Vorlagematerial 6 - chemisch gehärtetes Glas mit photographischer Emulsion - wird mittels Sprühkleber auf die Glasplatten 2 der Belichtungseinheit geklebt. Das zu belichtende Material 7 - beispielsweise eine Leiterrohplatte - wird nun zwischen die beiden Vorlagematerialien gelegt. Durch anschließendes Anlegen von Vakuum ≤ 0,2 bar zwischen den Glasplatten werden die Vorlagenmaterialien in Kontakt mit dem zu belichtenden Material gebracht, das dadurch belichtet werden kann.

Die mit der Erfindung erzielten Vorteile bestehen insbesondere darin, daß die Flexibilität des dimensionsstabilen chemisch gehärteten Glases als Trägermaterial auch bei starkem Andruck an das oftmals nicht vollständig ebene zu belichtende Material diese Unebenheiten ausgleicht, ohne zu brechen. Ein weiterer Vorteil besteht darin, daß durch diese Flexibilität die Handhabung dieses Vorlagenmaterials wegen seiner Bruchfestigkeit wesentlich einfacher ist. Ebenfalls kann die Materialstärke des Trägermaterials (5 mm bei konventionellen Glasmastern) auf Stärken von 0,2 mm - 3 mm, bevorzugt 1 mm, reduziert werden. Das hat zur Folge, daß die UV-Durchlässigkeit des Glases höher ist und kürzere Belichtungszeiten erzielt werden. Weiterhin ist der Platzbedarf für das dünnere Material bei Vorlagenarchivierung im Vergleich mit konventionellen Glasmastern wesentlich geringer.

## Ansprüche

1. Oberes und unteres Vorlagenmaterial für beidseitig gleichzeitige und paßgenaue Belichtung von lichtempfindlich beschichteten Materialien, beispielsweise Leiterrohplatten, jeweils bestehend aus Trägermaterial mit photographischer Emulsion, wie Silberhalogenid/Gelatine oder Diazoschichten, dadurch gekennzeichnet, daß das Trägermaterial aus chemisch gehärtetem Glas besteht.

2. Vorlagenmaterial nach Anspruch 1, dadurch gekennzeichnet, daß die Stärke des chemisch gehärteten Glases 0,2 bis 3 mm beträgt.